# EUROPÄISCHE PATENTSCHRIFT

(11) **EP 3 555 342 B1**
(45) Veröffentlichungstag und Bekanntmachung des Hinweises auf die Patenterteilung: **27.04.2022**
(21) Anmeldenummer: 17809210.2
(22) Anmeldetag: 16.11.2017
(51) Int. Cl.: C23C 14/34, C23C 14/35, C23C 14/50, G02B 1/10, H01J 37/34, B29D 11/00, C23C 14/56, H01J 37/32

(54) **VORRICHTUNG, VERFAHREN UND VERWENDUNG ZUR BESCHICHTUNG VON LINSEN**
DEVICE, METHOD AND USE FOR THE COATING OF LENSES
DISPOSITIF, PROCÉDÉ ET UTILISATION AUX FINS DE REVÊTEMENT DE LENTILLES

(30) Priorität: 14.12.2016 DE 102016014835; 16.12.2016 DE 102016014982; 21.12.2016 DE 102016125278
(43) Veröffentlichungstag der Anmeldung: 23.10.2019
(73) Patentinhaber: Schneider GmbH & Co. KG, 35112 Fronhausen (DE)
(72) Erfinder: SCHNEIDER, Gunter, 35037 Marburg (DE); FUHR, Markus, 63526 Erlensee (DE)
(74) Vertreter: Häckel, Stefan
(86) Internationale Anmeldenummer: PCT/EP2017/079432
(87) Internationale Veröffentlichungsnummer: WO 2018/108432

(56) Entgegenhaltungen:
- EP-A1- 0 723 036
- EP-A1- 0 945 524
- EP-A1- 1 359 236
- WO-A1-2016/202468
- DE-C1- 10 145 201
- JP-A- H10 317 135
- JP-A- 2012 158 835
- JP-A- 2013 249 489
- US-A1- 2004 216 992
- US-A1- 2005 109 616

## Beschreibung

Die vorliegende Erfindung betrifft eine Vorrichtung zur Beschichtung von Linsen gemäß dem Oberbegriff des Anspruchs 1, eine Verwendung von zwei Targets zur Beschichtung von Linsen gemäß dem Oberbegriff des Anspruchs 8 sowie ein Verfahren zur Beschichtung von Linsen gemäß dem Oberbegriff des Anspruchs 9.

Die vorliegende Erfindung betrifft generell das Beschichten von Linsen durch Sputtern, welches auch Kathodenzerstäubung genannt wird. Hierbei werden Atome aus einem Festkörper, dem sogenannten Target, durch Auftreffen von energiereichen Ionen herausgelöst und gehen in eine Gasphase über. Insbesondere betrifft die vorliegende Erfindung das sogenannte Magnetronsputtern, bei dem zusätzlich zu einem angelegten elektrischen Feld auch ein Magnetfeld hinter der Kathode bzw. dem Target angeordnet wird.

In der Praxis ist es schwierig, eine gleichmäßige Beschichtung der zu beschichtenden Linse zu erreichen, auch wenn aus dem Stand der Technik sind viele verschiedene Vorrichtungen und Verfahren zum Sputtern bekannt sind.

Die WO 03/023813 A1 offenbart eine Einrichtung zum Beschichten von Linsen durch Pulsmagnetron-Zerstäuben, wobei die Linsen linear entlang der Längserstreckung von zwei rohrförmigen, parallel verlaufenden Targets linear bewegt werden und dabei auch rotieren. Die Position der Targets und/oder ihre Ausrichtung auf den Randbereich der Substrate kann nach einem vorgegebenen Programm veränderbar sein. Dazu sind bewegliche und kippbare Halterungen für die Targets, insbesondere rechnergesteuerte mehrachsige Antriebe, enthalten. Hier ist eine gleichmäßige Beschichtung der Linsen nicht oder allenfalls nur sehr schwierig erreichbar.

JP 2012-158835 A betrifft eine Sputtereinrichtung für ein Substrat wie ein großflächiges Substrat oder eine konkave Linse. Die Einrichtung weist ein Target auf, das kleiner als das zu beschichtende Substrat ist. Bei der Beschichtung wird das Target horizontal entlang des Substrats bewegt. Bei gekrümmter Substratoberfläche wird der Abstand des Targets zur Substratoberfläche konstant gehalten, indem das Substrat vertikal bewegt wird, insbesondere synchron mit der Horizontalbewegung des Targets.

Die JP H10-317135 A betrifft eine Vorrichtung zum Korrigieren der Beschichtungsdicke beim Sputtern von optischen Linsen. In der Vorrichtung werden mehrere Linsen in einer rotierbaren Scheibe gehalten. Die Einrichtung weist zwei Targets auf, die auf unterschiedlichen Seiten der Scheibe angeordnet sind. In einem Beschichtungsvorgang werden die Linsen gleichzeitig von beiden Seiten beschichtet. Eine gleichmäßige Beschichtung wird hierbei dadurch erreicht, dass zwischen den Targets und Linsen jeweils Masken angeordnet werden, die bestimmte Linsenbereiche abschirmen.

Die EP 0 945 524 A1 offenbart eine Vorrichtung zum Beschichten eines Substrats, wie ein Brillenglas. Die Vorrichtung weist zwei Targets auf. Ein erstes Target ist kreisförmig und befindet sich mittig über der Linse, während ein zweites Target ringförmig und konzentrisch um das erste Target herum angeordnet ist. Das ringförmige Target ist ortsfest während das innere Target mittels einer Verstellvorrichtung hinsichtlich seines Abstandes zum anderen Target und damit zum Substrat verstellt werden kann. Die Verstellmöglichkeit erlaubt eine Anpassung an den jeweiligen Krümmungsradius des Substrats, sodass die Targets im Wesentlichen den gleichen Abstand vom Substrat ausweisen. Weiterer relevanter Stand der Technik ist in Dokument DE10145201C1 offenbart.

Der vorliegenden Erfindung liegt die Aufgabe zugrunde, eine Vorrichtung, eine Verwendung und ein Verfahren zur Beschichtung von Linsen anzugeben, wobei eine sehr gleichmäßige und/oder effiziente Beschichtung insbesondere von gekrümmten Oberflächen der Linsen bei einfachem Aufbau und/oder bei einfacher Beschickung ermöglicht wird.

Die obige Aufgabe wird durch eine Vorrichtung gemäß Anspruch 1, eine Verendung gemäß Anspruch 8 oder ein Verfahren gemäß Anspruch 9 gelöst. Vorteilhafte Weiterbildungen sind Gegenstand der Unteransprüche.

Gemäß einem Aspekt der vorliegenden Erfindung ist die Vorrichtung zur Beschichtung von Linsen vorzugsweise derart ausgebildet, dass die Targets verstellbar sind, um den Abstand zu mindestens einer zu beschichtenden Linse und/oder den Abstand der Targets zueinander zu verstellen bzw. anzupassen. So kann das Beschichtungsverhalten an die jeweils zu beschichtende(n) Linse(n) sehr einfach angepasst werden, insbesondere auch unter Berücksichtigung der zu beschichtenden Oberfläche(n). Beispielsweise kann so berücksichtigt werden, ob die Oberfläche konvex oder konkav gekrümmt ist und/oder wie stark die Oberfläche gekrümmt ist. Dementsprechend wird die Erzeugung einer möglichst gleichmäßigen Beschichtung auf der zu beschichtenden Oberfläche bzw. Linse ermöglicht oder zumindest erleichtert.

Die Targets bzw. die Sputterquellen mit den Targets sind vorzugswiese zwangsgeführt, insbesondere in einer Kulisse verstellbar geführt, um eine definierte Verstellung zu erleichtern oder sicherzustellen. Dies ist wiederum einer definierten Beschichtung der Linsen zuträglich.

Die Targets bzw. Sputterquellen sind vorzugsweise symmetrisch zu einer Mittelebene der Vorrichtung bzw. Targets verstellbar. Dies ist wiederum einer definierten Beschichtung zuträglich, da insbesondere auch die zu beschichtenden Linsen symmetrisch zu dieser Mittelebene für die Beschichtung angeordnet werden, besonders bevorzugt in einer Ebene parallel zu der gemeinsamen Ebene der Targets. Die Targets bzw. Sputterquellen sind vorzugsweise schräg zu einer Mittelebene der Vorrichtung bzw. Targets verstellbar. Dies ist wiederum einer definierten Verstellung und damit einem definierten Beschichtungsverhalten zuträglich.

Die Targets bzw. Sputterquellen sind mittels eines Stellantriebs, also insbesondere motorisch, verstellbar. Dies ist einer definierten und gegebenenfalls auch schnellen Verstellung, insbesondere in Abhängigkeit von jeweils zu beschichtenden Linsen, zuträglich.

Erfindungsgemäss sind den Targets bzw. zwei Targets ein gemeinsamer Stellantrieb zur gemeinsamen Verstellung der beiden Targets bzw. Sputterquellen zugeordnet.

Eine vorschlagsgemäße Verwendung von zwei vorzugsweise länglichen bzw. rohrförmigen, parallelen Targets zur Beschichtung von gekrümmten Oberflächen von Linsen zeichnet sich insbesondere dadurch aus, dass die Targets zur Veränderung des Abstands zu mindestens einer zu beschichtenden Linse und/oder des Abstands der Targets zueinander verstellt werden, um das Beschichtungsverhalten insbesondere an die zu beschichtende(n) Linse(n) anpassen zu können. Hierdurch ergeben sich entsprechende Vorteile.

Gemäß einem anderen, auch unabhängig realisierbaren Aspekt der vorliegenden Erfindung werden mehrere Targets mittels eines Stellantriebs gemeinsam, relativ zu mindestens einer zu beschichtenden Linse und/oder zueinander verstellt, um das Beschichtungsverfahren besonders bevorzugt individuell an die jeweils zu beschichtende(n) Linse(n). Hierdurch ergeben sich wiederum entsprechende Vorteile. Vorzugsweise erfolgt bei der vorschlagsgemäßen Vorrichtung und dem vorschlagsgemäßen Verfahren eine beidseitige Beschichtung der mindestens einen zu beschichtenden Linse in der (selben) Vorrichtung bzw. Beschichtungskammer insbesondere mit auf entgegengesetzten Seiten angeordneten Targets. Dies ist wiederum einer sehr einfachen bzw. effizienten Beschichtung zuträglich.

Vorzugsweise weist die Vorrichtung mindestens ein längliches oder rohrförmiges Target auf und ist die zu beschichtende Linse um eine relativ zu den Targets stationäre Achse rotierbar.

Insbesondere ist die Linse beim Beschichten nicht linear bewegbar, sondern es handelt sich vorzugsweise um eine stationäre Anordnung, wobei das Target und die Linse vorzugsweise um jeweils stationäre Achsen rotieren. So kann bei geringem baulichen Aufwand eine besonders gleichmäßige Beschichtung der Linse erreicht werden.

Vorzugsweise wird die zu beschichtende Linse vorzugsweise sowohl in einem ersten, zumindest im Wesentlichen homogenen Bereich als auch in einem zweiten, inhomogenen Bereich eines Ratenprofils der Abtragung eines Targets über dem Target gehalten und dabei rotiert. Somit wird eine besonders gleichmäßige Beschichtung insbesondere einer gekrümmten Oberfläche der Linse ermöglicht.

Insbesondere wird die zu beschichtende Linse in einem Endbereich oder dessen Nähe über dem vorzugsweise länglichen oder rohrförmigen Target gehalten. So kann eine besonders gute Ausnutzung der gerade zum Ende des Targets hin erhöhten Abgaberate und damit eine verbesserte Ausnutzung des zerstäubten Targetmaterials erfolgen.

Erfindungsgemäss werden zwei längliche bzw. rohrförmige, insbesondere parallele Targets zur Beschichtung von gekrümmten Oberflächen von Linsen eingesetzt, wobei die Linsen paarweise über den Targets angeordnet werden und vorzugsweise jeweils um eine stationäre Achse rotieren. Dies ermöglicht einen einfachen, kompakten Aufbau, wobei sehr gleichmäßige Beschichtungen der Linsen erreichbar sind.

Die vorgenannten Aspekte sowie die sich aus der weiteren Beschreibung ergebenden Merkmale und Aspekte der vorliegenden Erfindung können unabhängig voneinander, aber auch in beliebiger Kombination realisiert werden.

Weitere Aspekte, Vorteile und Merkmale der vorliegenden Erfindung ergeben sich aus den Ansprüchen und der folgenden Beschreibung eines bevorzugten Ausführungsbeispiels anhand der Zeichnung. Es zeigt:
- Fig. 1: einen schematischen Schnitt einer vorschlagsgemäßen Vorrichtung zur Beschichtung von Linsen;
- Fig. 2: eine schematische Draufsicht der Vorrichtung;
- Fig. 3: eine schematische Seitenansicht der Vorrichtung mit einem schematisch angedeuteten Ratenprofil; und
- Fig. 4: eine schematische Draufsicht der Vorrichtung entsprechend Fig. 2, jedoch mit alternativ angeordneten Linsen.

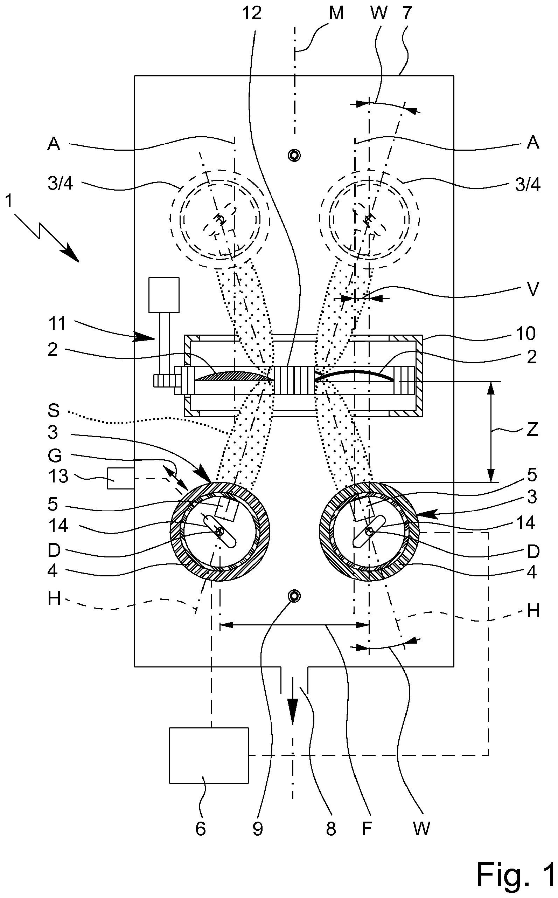

Fig. 1 zeigt in einem sehr schematischen Schnitt eine vorschlagsgemäße Vorrichtung 1 zur Beschichtung von Linsen 2, vorzugsweise optischen bzw. ophthalmischen Linsen bzw. Brillengläsern, insbesondere aus Kunststoff.

Die Vorrichtung 1 ist insbesondere zum Beschichten der Linsen 2 durch Sputtern, auch Kathodenzerstäubung genannt, ausgebildet. Besonders bevorzugt erfolgt ein sogenanntes Magnetronsputtern. Zusätzlich zu einem elektrisch angelegten Feld wird hierbei auch ein Magnetfeld benutzt bzw. angelegt, worauf später noch etwas näher eingegangen wird.

Besonders bevorzugt werden gekrümmte, insbesondere konkave Oberflächen der Linsen 2 erfindungsgemäß beschichtet. In Fig. 1 ist schematisch bei der auf der rechten Seite dargestellten Linse 2 eine solche gekrümmte Oberfläche angedeutet. Jedoch können grundsätzlich auch konvexe Oberflächen oder sonstige Oberflächen der Linsen 2 entsprechend beschichtet werden.

Die Vorrichtung 1 weist mindestens eine Sputterquelle 3, hier vorzugsweise zwei Sputterquellen 3, auf.

Die Vorrichtung 1 bzw. die jeweilige Sputterquelle 3 weist ein Target 4 auf, dessen Material beim Beschichten bzw. Sputtern abgetragen wird und - insbesondere zusammen mit anderen Bestandteilen der Gasatmosphäre - die gewünschte Beschichtung auf der jeweiligen Linse 2 bzw. deren zu beschichtenden Oberfläche bildet.

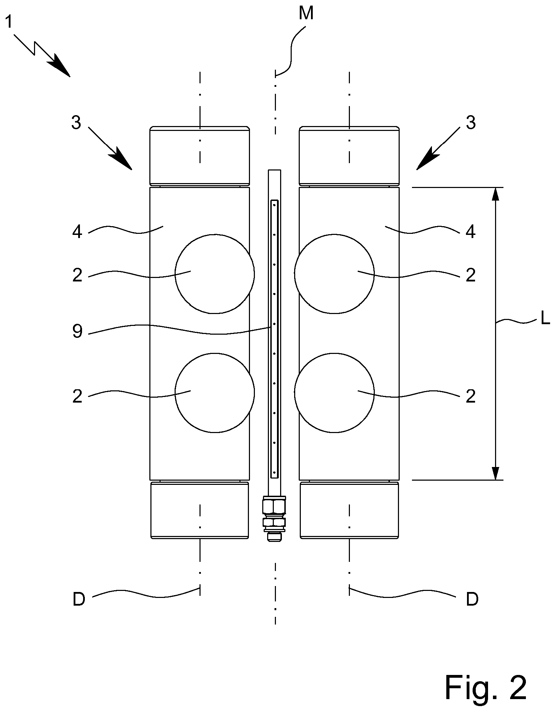

Fig. 2 zeigt die Vorrichtung 1 bzw. Sputterquellen 3 in einer schematischen Draufsicht.

Die Sputterquellen 3 bzw. Targets 4 sind beim Darstellungsbeispiel bevorzugt zumindest im Wesentlichen länglich bzw. rohrförmig oder zylindrisch ausgebildet.

Die Targets 4 sind insbesondere hohlzylindrisch bzw. rohrförmig ausgebildet.

Die Sputterquellen 3 bzw. Targets 4 sind vorzugsweise parallel zueinander angeordnet.

Vorzugsweise sind die Targets 4 drehbar bzw. rotierbar um Drehachsen D. Die Drehachsen D verlaufen vorzugsweise in einer gemeinsamen Ebene und/oder insbesondere parallel zueinander, wie in den Fig. 1 und 2 angedeutet, können alternativ aber auch zueinander geneigt sein. Die Drehachsen D entsprechen vorzugsweise den Längsachsen der Sputterquellen 3.

Besonders bevorzugt sind die Sputterquellen 3 bzw. Targets 4 baugleich und/oder identisch aufgebaut, so dass nachfolgend primär nur auf den Aufbau einer Sputterquelle 3 bzw. eines Targets 4 eingegangen wird. Jedoch können die Sputterquellen 3 bzw. Targets 4 auch grundsätzlich unterschiedlich ausgebildet sein.

Die Sputterquelle 3 weist vorzugsweise eine Magnetanordnung 5 auf, die dem jeweiligen Target 4 zur Erzeugung des bereits genannten Magnetfelds und damit einer gerichteten Sputterwolke S zugeordnet ist, wie in Fig. 1 schematisch angedeutet. Insbesondere ist die Magnetanordnung 5 unter bzw. in dem jeweiligen Target 4 angeordnet.

Die Vorrichtung 1 weist eine Spannungsquelle 6 auf, wie in Fig. 1 angedeutet, um die Sputterquellen 3 bzw. Targets 4 - insbesondere abwechselnd - als Kathode betreiben bzw. zum Sputtern mit der erforderlichen Spannung, insbesondere in Form von Pulsen, beaufschlagen zu können.

Besonders bevorzugt werden die Sputterquellen 3 bzw. Targets 4 abwechselnd mit Gleichstrom (Pulsen) betrieben bzw. beaufschlagt. Dies wird auch als "Bi-polar DC" bezeichnet. Abwechselnd dient dann eine Sputterquelle 3 bzw. ein Target 4 als Kathode und die andere Sputterquelle 3 bzw. das andere Target 4 als Anode.

Alternativ kann ein Betrieb mit Wechselstrom oder ein sonstiger Betrieb erfolgen.

Alternativ oder zusätzlich können auch eine oder mehrere zusätzliche oder separate Anoden eingesetzt werden, auch wenn dies nicht bevorzugt ist.

Die Vorrichtung 1 weist vorzugsweise eine Beschichtungskammer 7 auf, in der die Beschichtung erfolgt bzw. die Sputterquellen 3 angeordnet sind.

Das bevorzugte abwechselnde Betreiben der Sputterquellen 3 bzw. Targets 4 als Kathode und Anode führt dazu, dass keine gehäuseseitige oder feste Gegenelektrode erforderlich ist. Insbesondere wird die Beschichtungskammer 7 nicht als Gegenelektrode eingesetzt. Hierdurch lässt sich eine unerwünschte Verschmutzung bzw. Ablagerung von Targetmaterial auf der Gegenelektrode minimieren bzw. ein besonders stabiles Verfahren oder Beschichten auch unabhängig von einer Verschmutzung der Beschichtungskammer 7 erreichen. Dementsprechend können hierdurch erforderliche Reinigungen und Wartungen reduziert werden.

Weiter können die Targets 4 sehr leicht gewechselt werden. Auch dies erleichtert den Service.

Die Beschichtungskammer 7 ist insbesondere mittels einer hier nur schematisch angedeuteten Einrichtung 8, wie einem Anschluss, einer Vakuumpumpe o. dgl., in gewünschter Weise, vorzugsweise auf ein Hochvakuum und/oder auf einen Druck von unter 0,1 Pa, evakuierbar.

Die Einrichtung bzw. Vakuumpumpe 8 ist insbesondere auf der dem Träger 10 bzw. den Linsen 2 abgewandten Seite der Sputterquellen 3 bzw. Targets 4 und/oder bevorzugt in einer Mittelebene M der Vorrichtung 1 bzw. Beschichtungskammer 7 bzw. Targets 4 angeordnet.

Die Vorrichtung 1 bzw. Beschichtungskammer 7 weist vorzugsweise eine schematisch angedeutete Gaszuführung 9, insbesondere in Form einer sich in den Beschichtungsraum erstreckenden Gaslanze, auf.

Die Gaszuführung 9 ist vorzugsweise unterhalb der Sputterquellen 3 bzw. Targets 4 und/oder dazwischen, besonders bevorzugt in der Mittelebene M der Vorrichtung 1 bzw. Beschichtungskammer 7 angeordnet.

Die Gaszuführung 9 ist vorzugsweise rohrförmig und/oder stabartig ausgebildet und/oder mit vorzugsweise in einer Reihe angeordneten und/oder nach oben weisenden Gasauslässen versehen.

Die Vorrichtung 1 weist vorzugsweise einen Träger 10 zur Halterung der Linsen 2 auf, wie in Fig. 1 angedeutet.

In Fig. 2 und in weiteren Figuren ist der Träger 10 aus Veranschaulichungsgründen nicht dargestellt.

Die zu beschichtenden Linsen 2 sind vorzugsweise jeweils um eine Achse A drehbar bzw. rotierbar. Die Vorrichtung 1 bzw. der Träger 10 ist zur entsprechenden drehbaren Halterung und insbesondere zum entsprechenden Antreiben der Linsen 2 ausgebildet. Insbesondere weist die Vorrichtung 1 einen entsprechenden, in Fig. 1 nur schematisch angedeuteten Drehantrieb 11 auf, vorzugsweise um alle Linsen 2 des Trägers 10 gemeinsam anzutreiben.

Der Träger 10 ist vorzugsweise zusammen mit mindestens zwei Linsen 2 bzw. allen Linsen 2 bzw. hier vier Linsen 2, die gleichzeitig in der Vorrichtung 1 bzw. Beschichtungskammer 7 beschichtet werden, wechselbar.

Insbesondere hält der Träger 10 die Linsen 2 - insbesondere um eigene bzw. unterschiedliche Achsen A - drehbar, besonders bevorzugt drehbar gekoppelt. Besonders bevorzugt weist der Träger 10 eine Drehkopplung 12, beispielsweise über ein entsprechendes Getriebe, auf, wie in Fig. 1 schematisch angedeutet.

Vorzugsweise wird der Träger 10 selbst während des Beschichtens nicht bewegt, sondern nur die davon gehaltenen Linsen 2 rotiert. Vorzugsweise ist der Träger 10 beim Einsetzen oder Einschieben in die Vorrichtung 1 bzw. Beschichtungskammer 7 automatisch antriebsmäßig oder getriebemäßig, insbesondere mit dem Drehantrieb 11 o. dgl. der Vorrichtung 1 koppelbar.

Der Träger 10 gestattet eine schnelle Beschickung der Vorrichtung 1 bzw. Beschichtungskammer 7 mit den zu beschichtenden Linsen 2 bzw. eine schnelle Entnahme der beschichteten Linsen 2.

Die Vorrichtung 1 bzw. Beschichtungskammer 7 ist vorzugsweise über eine nicht dargestellte Zugangsöffnung mit den zu beschichtenden Linsen 2 bzw. dem Träger 10 beschickbar. Die Zugangsöffnung ist vorzugsweise mittels des Trägers 10 oder durch einen nicht dargestellten Verschluss insbesondere gasdicht verschließbar.

Die Beschichtungskammer 7 ist zum Beschichten vorzugsweise gasdicht verschließbar.

Der Träger 10 ist vorzugsweise generell bei Vorrichtungen zur Beschichtung von Linsen 2 einsetzbar, insbesondere also auch bei anderen Beschichtungsverfahren als dem Sputtern.

Die Drehachsen D bzw. Längserstreckungen L der Targets 4 verlaufen vorzugsweise in einer gemeinsamen Ebene, besonders bevorzugt einer Vertikal- oder Horizontalebene.

Die Linsen 2 sind vorzugsweise oberhalb bzw. auf einer Seite der vorgenannten Ebene angeordnet.

Vorzugsweise ist jede Linse 2 über einem zugeordneten Target 4 angeordnet. Der Begriff "über" kann sich auf die vertikale Höhe gegenüber dem zugeordneten Target 4 und/oder darauf beziehen, dass die zu beschichtende Oberfläche der Linse 2 wenigstens eine Flächennormale aufweist, die das Target 4 und besonders bevorzugt deren Drehachse D schneidet.

Vorzugsweise sind die Linsen 2 paarweise einer Sputterquelle 3 bzw. einem Target 4 zugeordnet.

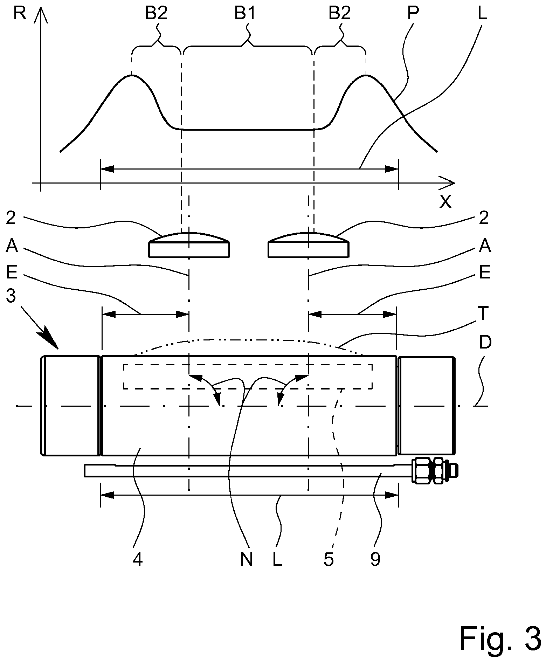

Insbesondere sind jeweils zwei Linsen 2 über einem gemeinsamen Target 4 angeordnet, wie in Fig. 2 und in der schematischen Seitenansicht gemäß Fig. 3 angedeutet.

Besonders bevorzugt ist die Vorrichtung 1 bzw. der Träger 10 zur Aufnahme von zwei Paaren von Linsen 2, also von insgesamt vier Linsen 2, ausgebildet, wobei jeweils zwei Linsen 2 einer gemeinsamen Sputterquelle 3 bzw. einem gemeinsamen Target 4 zugeordnet sind. Nachfolgend wird auf die bevorzugte Anordnung und Ausrichtung von einem solchen Paar von Linsen 2, die einem gemeinsamen Target 4 zugeordnet sind, näher eingegangen. Diese Ausführungen und Erläuterungen gelten insbesondere entsprechend für das andere Paar von Linsen 2, da die Vorrichtung 1 bzw. die Anordnung von Linsen 2 in der Vorrichtung 1 und/oder die Anordnung der Sputterquellen 3 bzw. Targets 4 besonders bevorzugt weitestgehend symmetrisch bzgl. einer Mittelebene M - in den Figuren 1 und 2 der auf der Zeichnungsebene senkrecht stehenden Mittelebene M - ist.

Die einem gemeinsamen Target 4 zugordneten Linsen 2 sind vorzugsweise in einer Richtung parallel zur Längserstreckung L bzw. Drehachse D des Targets 4 versetzt angeordnet. Diese Richtung wird auch als X-Richtung bzw. X-Achse insbesondere bei dem in Fig. 3 schematisch angedeuteten Diagramm bezeichnet.

Die Linsen 2 bzw. deren Achsen A sind vorzugsweise symmetrisch bezüglich der Längserstreckung L des Targets 4 angeordnet und/oder weisen einen Versatz bzw. Abstand E vom jeweiligen Ende des Targets 4 in axialer Richtung bzw. X-Richtung auf.

Insbesondere sind die Linsen 2 in einem Endbereich oder dessen Nähe des jeweiligen Targets 4 angeordnet, wie in Fig. 1 und 2 angedeutet.

Das Diagramm in Fig. 3 veranschaulicht qualitativ die Rate R der Abtragung des Targets 4 bei der Beschichtung in Abhängigkeit von der axialen Position bzw. X-Position. So ergibt sich ein Ratenprofil P der Rate R über X, also in Richtung der Längserstreckung L des Targets 4.

Das Ratenprofil P weist im mittigen axialen Bereich des Targets 4 einen ersten, zumindest im Wesentlichen homogenen Bereich B1 auf. Die Rate R ist in dem ersten Bereich B1 also zumindest im Wesentlichen konstant bzw. variiert entlang der axialen Erstreckung des Targets 4 in diesem Bereich B1 allenfalls nur sehr gering, insbesondere weniger als 5%. Vorzugsweise ist "im wesentlichen konstant" erfindungsgemäß so zu verstehen, dass die Rate R entlang der Längserstreckung L - hier im Bereich B1 - um weniger als 5 % variiert.

Das Ratenprofil P weist weiter einen zweiten, nicht homogenen bzw. inhomogenen Bereich B2 auf. In diesem zweiten Bereich B2 variiert die Rate R sehr stark, steigt insbesondere zum Ende des Targets 4 hin stark an, besonders bevorzugt um mehr als 10%.

Die zum Ende des Targets 4 bzw. jeweiligen Magnetanordnung 5 hin ansteigende Rate R der Abtragung des Targets 4 im zweiten Bereich B2 lässt sich durch die im Endbereich erhöhte Magnetfeldstärke erklären.

Aus Fig. 3 ist ersichtlich, dass sich an den ersten Bereich B1 auf beiden Seiten bzw. zum jeweiligen Ende des Targets 4 hin jeweils ein zweiter Bereich B2 im genannten Sinn anschließt.

Die Linsen 2 sind vorzugsweise jeweils derart - hier in axialer Erstreckung L bzw. X-Richtung über den Target 4 - angeordnet, dass die Linse 2 jeweils sowohl in dem ersten Bereich B1 als auch in dem zweiten Bereich B2 angeordnet ist bzw. diese überdeckt. Besonders bevorzugt ist die Mitte bzw. Achse A der jeweiligen Linse 2 in der Nähe des Übergangs vom ersten Bereich B1 zum zweiten Bereich B2 angeordnet. Die Abweichung der Achse A von diesem Übergang beträgt vorzugsweise weniger als 30%, insbesondere weniger als 20%, besonders bevorzugt weniger als 10% des Linsendurchmessers.

Es hat sich gezeigt, dass durch die vorgenannte Anordnung der Linse 2 sowohl im ersten Bereich B1 als auch im zweiten Bereich B2 unter Berücksichtigung der Rotation der Linse 2 um die Achse A bei der Beschichtung eine besonders gleichmäßige Beschichtung erzielbar ist.

Die Achse A, um die die Linse 2 bei der Beschichtung jeweils rotiert, ist vorzugsweise relativ zu dem Target 4 bzw. der Sputterquelle 3 oder Drehachse D stationär bzw. fest. Die Linse 2 ist also während des Beschichtens stationär zu dem Target 4 bzw. den Targets 4, auch wenn die Linse 2 optional bzw. bevorzugt rotiert.

Insbesondere wird eine lineare Bewegung bzw. eine Schwerpunktbewegung, wie eine Kreisbewegung, zwischen der Sputterquelle 3 bzw. des Targets 4 bzw. den Drehachsen D einerseits und der zu beschichtenden Linse 2 bzw. Linsen 2 bzw. Achsen A andererseits vermieden bzw. ausgeschlossen. Dies ist einem besonders einfachen Aufbau zuträglich.

Der Versatz bzw. Abstand E der Rotationsachse A der Linse 2 von dem jeweiligen Ende des Targets 4 beträgt vorzugsweise mehr als das 1,0-fache oder 1,5-fache des Linsendurchmessers und/oder Targetdurchmessers.

Der Abstand E ist vorzugsweise fest. Optional erfolgt eine Anpassung oder Verstellung des Abstands E der Rotationsachse A der Linse 2 von dem jeweiligen Ende des Targets 4 in Abhängigkeit von dem Durchmesser und/oder der Krümmung bzw. Form der zu beschichtenden Linse 2 bzw. Oberfläche.

Der (vertikale) Abstand Z der Linse 2 vom zugeordneten Target 4 ist in Fig. 1 angedeutet und beträgt vorzugsweise mehr als das 1,0-fache des Linsendurchmessers oder Targetdurchmessers.

Der (vertikale) Abstand Z der Linse 2 vom zugeordneten Target 4 beträgt vorzugsweise mehr als etwa 60 mm und/oder weniger als 150 mm, insbesondere weniger als 130 mm.

Der Abstand Z ist vorzugsweise fest. Optional erfolgt eine Anpassung oder Verstellung des (vertikalen) Abstands Z der Linse 2 vom zugeordneten Target 4 in Abhängigkeit von dem Durchmesser und/oder der Krümmung bzw. Form der zu beschichtenden Linse 2 bzw. Oberfläche.

Der Targetdurchmesser beträgt vorzugsweise etwa 70 bis 130 mm.

Vorzugsweise ist der Target(außen)durchmesser über die Länge zumindest im Wesentlichen konstant.

Das Target 4 ist vorzugsweise also zylindrisch bzw. hohlzylindrisch ausgebildet.

Die Achsen A von zwei einem gemeinsamen Target 4 zugeordneten Linsen 2 verlaufen vorzugsweise in einer gemeinsamen Ebene und insbesondere parallel zueinander.

Die Achsen A verlaufen vorzugsweise quer oder senkrecht zu der Targetebene bzw. gemeinsamen Ebene der Drehachsen D bzw. zu der Drehachse D des zugeordneten Targets 4.

Die Achsen A können in ihrer gemeinsamen Ebene auch relativ zueinander, insbesondere aufeinander zu oder nach außen bzw. voneinander weg geneigt sein. Demensprechend sind die Linsen 2 dann mehr einander angenähert oder voneinander abgerückt, insbesondere ggf. so dass die zu beschichtenden Oberflächen der zwei Linsen 2 etwas zueinander hin verkippt werden bzw. etwas mehr zur Mitte des jeweiligen Targets 4 hin weisen. Dementsprechend kann der Neigungswinkel N der Achsen A zu den Drehachsen D von den bevorzugten 90°, wie in Fig. 3 dargestellt, abweichen und entweder weniger als 90°, beispielsweise etwa 70° bis 85°, oder mehr als 90°, beispielsweise etwa 95° bis 110°, betragen.

Der Neigungswinkel N ist vorzugsweise fest. Besonders bevorzugt erfolgt aber optional eine Anpassung oder Verstellung des Neigungswinkels N in Abhängigkeit von dem Durchmesser und/oder der Krümmung bzw. Form der zu beschichtenden Linse 2 bzw. Oberfläche.

Die Rotationsachse A der Linse 2 kann auch in Y-Richtung, also in einer Richtung quer zur Drehachse D in horizontaler Richtung bzw. zur Mitte zwischen den beiden Drehachsen D der Targets 4 hin verschoben sein, insbesondere so dass sich ein Versatz oder Abstand V zwischen der Linsenachse A und der zugeordneten Target achse D bildet, wie in Fig. 1 für die auf der rechten Seite angeordnete Linse 2 angedeutet (gleiches gilt vorzugsweise natürlich auch für die auf der linken Seite angeordnete Linse 2). Der Versatz bzw. Abstand V beträgt vorzugsweise weniger als 20%, insbesondere weniger als 10% des Linsendurchmessers und/oder Targetdurchmessers.

Der Abstand V ist vorzugsweise fest. Optional erfolgt eine Anpassung oder Verstellung des Abstands V zwischen der Linsenachse A und der zugeordneten Target achse D in Abhängigkeit von dem Durchmesser und/oder der Krümmung bzw. Form der zu beschichtenden Linse 2 bzw. Oberfläche.

Vorzugsweise werden der Neigungswinkel N und/oder die Lage der Achsen A bzw. die Abstände E, V und/oder Z durch den Träger 10 (mit) festgelegt.

Die Sputterquellen 3 bzw. Targets 4 liegen vorzugsweise in einer gemeinsamen Ebene und/oder erstrecken sich vorzugsweise parallel zueinander.

Der Abstand F der Sputterquellen 3 bzw. Targets 4 bzw. Drehachsen D ist in Fig. 1 schematisch angedeutet. Der Abstand F ist besonders bevorzugt variabel. Vorzugsweise erfolgt nämlich eine Anpassung oder Verstellung des Abstands F insbesondere linsenspezifisch, besonders bevorzugt in Abhängigkeit von dem Durchmesser und/oder der Krümmung bzw. Form der zu beschichtenden Linse(n) 2 bzw. Oberfläche(n), also individuell.

Besonders bevorzugt sind die Sputterquellen 3 bzw. Targets 4 zur Veränderung des Abstands Z zu der mindestens einen zu beschichtenden Linse 2 und/oder des Abstands F der Targets 4 zueinander verstellbar.

Alternativ oder zusätzlich ist mindestens eine Sputterquelle 3 bzw. ein Target 4 relativ zu der Linse 2, vorzugsweise mittels eines Stellantriebs 13, zur insbesondere individuellen Anpassung des Abstands Z und/oder V und/oder E und/oder F verstellbar.

Die Verstellung dient insbesondere der Anpassung des Beschichtungsverhaltens an die (jeweilige) Linse 2.

Die Verstellung erfolgt vorzugsweise vor dem Beschichten, also insbesondere nicht während des Beschichtens. Jedoch ist grundsätzlich auch eine - ggf. langsame - Verstellung während des Beschichtens zur weiteren Vergleichmäßigung der aufgebrachten Beschichtung möglich.

Der Stellantrieb 13 umfasst vorzugsweise einen Schrittmotor oder Stellmotor.

Der Stellantrieb 13 arbeitet vorzugsweise elektrisch, pneumatisch oder hydraulisch.

Der Stellantrieb 13 greift vorzugsweise über ein Getriebe, insbesondere Hebelgetriebe, besonders bevorzugt an der jeweiligen Sputterquelle 3 bzw. Drehachse D, an.

Besonders bevorzugt erfolgt (nur) eine Verstellung der Sputterquellen 3 bzw. Targets 4. Alternativ oder zusätzlich ist auch eine Verstellung der Linsen 2, insbesondere des Trägers 10 mit den Linsen 2 möglich.

Besonders bevorzugt dient der Stellantrieb 13 der gemeinsamen Verstellung der Sputterquellen 3 bzw. Targets 4.

Unter "Verstellung" ist vorschlagsgemäß insbesondere eine Bewegung G bzw. Veränderung der Lage zu verstehen, wie in Fig. 1 beispielhaft nur für die untere linke Sputterquelle 3 bzw. deren Target 4 angedeutet.

Besonders bevorzugt sind die Sputterquellen 3 bzw. Targets 4 (nur) schräg, linear, gegenläufig und/oder symmetrisch zu der Mittelebene M verstellbar.

Besonders bevorzugt sind die Sputterquellen bzw. Targets 4 derart gekoppelt, insbesondere über ein Hebelgetriebe oder dergleichen, dass diese nur gemeinsam verstellbar sind und/oder immer parallel zueinander ausgerichtet bleiben und/oder immer mit ihrer gemeinsamen Ebene parallel zu der Hauptebene des Trägers 3 bzw. der Linsen 2 ausgerichtet bleiben und/oder nur parallel verschoben werden können.

Besonders bevorzugt sind die Sputterquellen 3 bzw. Targets 4 mittels einer Zwangsführung, insbesondere einer Kulisse 14, verstellbar geführt, wie in Fig. 1 nur schematisch angedeutet.

Vorzugsweise sind die Vorrichtung 1 und das vorschlagsgemäße Verfahren derart ausgebildet, dass die Linsen 2 beidseitig - also von beiden bzw. entgegengesetzten Seiten - beschichtet werden (können). Insbesondere sind hierzu die Sputterquellen 3 bzw. Targets 4 auf entgegengesetzten Seiten des Trägers 10 bzw. der zu beschichtenden Linse(n) 2 angeordnet, wie in Fig. 1 schematisch durch das oben zusätzlich gestrichelt dargestellte Paar von Sputterquellen 3 bzw. Targets 4 angedeutet.

So ist insbesondere ein beidseitiges Beschichten der Linse(n) 2 in der (selben) Vorrichtung 1 bzw. Beschichtungskammer 7 möglich.

Das Beschichten der beiden Seiten kann nacheinander oder wahlweise auch gleichzeitig erfolgen.

Insbesondere ist auf jeder Seite des Trägers 10 bzw. der Linsen 2 jeweils ein Paar von Sputterquellen 3 bzw. Targets 4 angeordnet, wobei für jedes Paar die obigen Ausführungen und nachfolgenden Ausführungen gelten, so dass eine diesbezügliche Wiederholung unterbleiben kann.

Für die beidseitige Beschichtung ist der Träger 10 vorzugsweise entsprechend von beiden Seiten offen, so dass die davon gehaltenen Linsen 2 insbesondere ohne Umgreifen oder Umspannen von beiden Seiten in gewünschter Weise beschichtet werden können. Beispielsweise ist der Träger 10 hierzu auf seinen entgegengesetzten Seiten mit entsprechenden Öffnungen versehen. Beispielsweise werden ringförmige Zahnräder bzw. Halteelemente oder sonstige Elemente zur umfangsseitigen Halterung der Linsen 2 eingesetzt, wobei diese Elemente vorzugsweise gleichzeitig die Drehkopplung 12 bilden oder ermöglichen.

Optional weist jede Seite bzw. die auf entgegengesetzten Seiten angeordneten Sputterquellen 3 bzw. Targets 4 jeweils eine eigene Gaszuführung 9 und/oder eigene Einrichtung bzw. Vakuumpumpe 8, Spannungsquelle 6 und/oder Verstellung, wie einen Halteantrieb 13, auf. Jedoch können auch grundsätzlich Komponenten oder Bauteile, wie die Spannungsquelle 6 oder Vakuumpumpe 8, gemeinsam oder abwechselnd genutzt werden.

Die beim Beschichten auftretende Sputterwolke S, also das zerstäubte Targetmaterial, wird mittels des bereits genannten Magnetfelds bzw. der Magnetanordnung 5 jeweils zumindest im Wesentlichen in eine gewünschte Richtung gelenkt. Diese in Fig. 1 gestrichelt angedeutete Hauptrichtung H der Ausbreitung der Sputterwolke S ist durch entsprechende Anordnung bzw. Ausrichtung der Magnetanordnung 5 beeinflussbar, insbesondere festlegbar.

Beim Darstellungsbeispiel ist die Hauptrichtung H in der Schnittebene senkrecht zu den Drehachsen D und/oder der beiden Targets 4 vorzugsweise zueinander und/oder um den Winkel W (ausgehend von einer parallelen Ausrichtung) geneigt.

Vorzugsweise ist der Winkel W einstellbar bzw. anpassbar, insbesondere durch entsprechende Verstellung oder Ansteuerung der Magnetanordnungen 5.

Der Winkel W beträgt vorzugsweise weniger als 10°, insbesondere weniger als 7°, besonders bevorzugt weniger als 5°.

Wie bereits angesprochen, können die Hauptrichtungen H der beiden Sputterwolken S auch parallel zueinander und/oder senkrecht zu der Erstreckungsebene der Targets 4 bzw. Ebene mit dem Drehachsen D verlaufen.

Vorzugsweise verlaufen die Hauptrichtungen H vertikal nach oben oder enthalten eine solche Richtungskomponente. Alternativ kommt eine horizontale Ausrichtung der Hauptrichtungen H vor. Die Anordnung der Linsen 2 und Sputterquellen 3 bzw. Targets 4 muss dann natürlich entsprechend gewählt werden.

Vorzugsweise werden die Linsen 2 bei der vorschlagsgemäßen Vorrichtung 1 und bei dem vorschlagsgemäßen Verfahren jeweils sowohl in dem ersten Bereich B1 als auch in dem zweiten Bereich B2 gehalten und dabei rotiert. Hierdurch ist eine besonders gleichmäßige Beschichtung erreichbar.

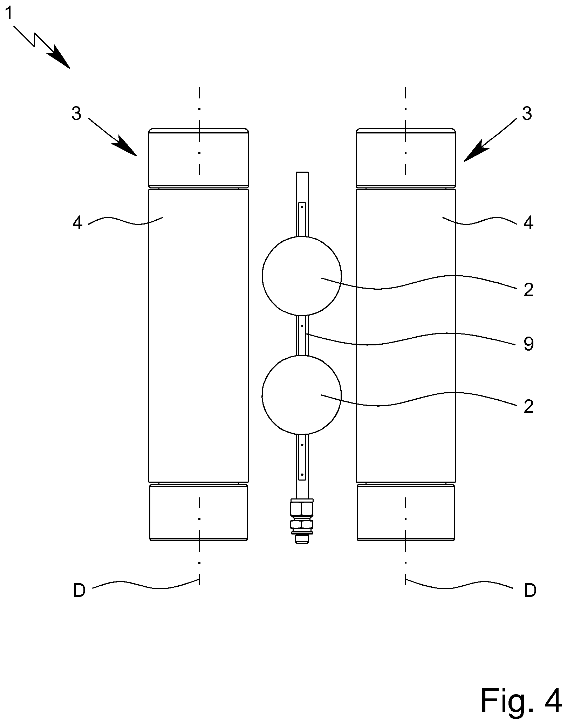

Besonders bevorzugt werden die Linsen 2 jeweils paarweise beschichtet, insbesondere werden jeweils gleichzeitig zwei Paare von Linsen 2 beschichtet. Grundsätzlich ist jedoch auch möglich, nur ein Paar von Linsen 2 in der Vorrichtung 1 vorschlagsgemäß zu beschichten. Hierzu werden die beiden Linsen dann vorzugsweise über einen gemeinsamen Taget 4 und/oder zwischen den beiden Targets 4, wie schematisch in Fig. 4 in einer alternativen Anordnung gezeigt, angeordnet.

Vorzugsweise wird das Ratenprofil P nicht durch Verteilungsblenden oder dergleichen in der Vorrichtung 1 bzw. Beschichtungskammer 7 beeinflusst oder homogenisiert. Dies ist insbesondere im Hinblick auf unerwünschte Abscheidungen auf derartigen Blenden vorteilhaft.

Gemäß einem auch unabhängig realisierbaren Aspekt der vorliegenden Erfindung kann der Außendurchmesser des Targets 4 über die axiale Erstreckung bzw. Länge oder Längserstreckung L des Targets 4 variieren, wie durch die zweipunktierte Strichlinie bzw. Targetoberfläche T in Fig. 3 schematisch angedeutet.

Insbesondere kann das Target 4 beispielsweise in der Mitte dicker als an den Endbereichen und/oder beispielsweise bauchig ausgebildet sein.

In der Mitte bzw. zwischen den Rotationsachsen A der Linsen 2 bzw. zwischen den (sich sonst bildenden) Bereichen B2 ist der Außendurchmesser des Targets 4 vorzugsweise zumindest im Wesentlichen konstant und/oder beispielsweise um mehr als 4 % größer als an den Enden des Targets 4, wie in Fig. 3 angedeutet.

Insbesondere kann der Außendurchmesser auch nur zu den Endbereichen des Targets 4 hin, insbesondere in den Bereichen B2 bzw. nur im Endbereich von weniger als 25 % der Länge L des Targets 4, jeweils reduziert sein bzw. abnehmen.

Grundsätzlich kann der Außendurchmesser in Längserstreckung L einen beliebigen Verlauf aufweisen, bedarfsweise auch (partiell) konvex, konkav oder gewellt.

Vorzugsweise variiert der Außendurchmesser des Targets 4 über die Längserstreckung bzw. Länge L des Targets 4 um mehr als 4 %.

Besonders bevorzugt wird das Ratenprofil P durch Variation des Außendurchmessers über die Länge L des Targets 4 in gewünschter Weise modifiziert, beispielsweise vergleichmäßigt.

Alternativ oder zusätzlich zu der Variation des Außendurchmessers kann auch das Magnetfeld bzw. die Magnetfeldstärke der Magnetanordnung 5 über die Länge L des Targets 4 bzw. der Sputterquelle 3 variieren, insbesondere zum Ende hin jeweils abnehmen und/oder im Bereich der Mitte größer sein, insbesondere um mehr als 4 %, um das Ratenprofil P in gewünschter Weise zu modifizieren, besonders bevorzugt zu vergleichmäßigen, und/oder um auch bei variierendem Außendurchmesser des Targets 4 eine bestimmte bzw. gewünschte und/oder zumindest im Wesentlichen konstante Stärke des Magnetfelds auf der Targetoberfläche, insbesondere auch unter Berücksichtigung des optional variierenden Außendurchmessers, zu erreichen.

Durch die vorgenannten Variationen von Außendurchmesser und/oder Magnetfeld wird das Ratenprofil P vorzugsweise derart vergleichmäßigt, modifiziert oder festgelegt, dass insbesondere unter Berücksichtigung der Positionierung der zu beschichtenden Linse 2 relativ zu dem Target 4 (beispielsweise der Lage der Rotationsachse A der Linse 2 und der Entfernung der Linse 2) und/oder unter Berücksichtigung der Form und/oder Größe der zu beschichtenden Oberfläche der Linse 2 eine gewünschte, insbesondere gleichmäßige oder in sonstiger Weise definierte, ggf. auch ungleichmäßige, beispielsweise zum Rand hin ansteigende oder abnehmende Beschichtung der Linse 2 erreichbar ist bzw. erreicht wird.

Die Linsen 2 rotieren vorzugsweise zentrisch um die jeweilige Achse A, insbesondere bezüglich der geometrischen Mitte der Linse 2.

Gemäß einer nicht dargestellten Ausführungsvariante können die Linsen 2 optional auch exzentrisch bezüglich der Rotationsachse A rotieren bzw. eingespannt sein. Die Exzentrität ist dabei vorzugsweise kleiner als der Radius der Linse 2, kann ggf. auch größer sein.

Insbesondere schneidet die Rotationsachse A also die jeweilige Linse 2.

Die Achse A verläuft vorzugsweise senkrecht zur Hauptebene der jeweiligen Linse 2.

Jede der Linsen 2 ist vorzugsweise um eine eigene Achse A rotierbar.

Die Achse A verläuft vorzugsweise quer, optional senkrecht, zu der Längserstreckung bzw. Drehachse D des zugeordneten Targets 4.

Insbesondere schneidet die Rotationsachse A der jeweiligen Linse 2 das zugeordnete Target 4, wie in Fig. 1 angedeutet, oder optional die Längs- bzw. Drehachse D des zugeordneten Targets 4.

Die Linse 2 weist während des Beschichtens bzw. Rotierens mit ihrer zu beschichtenden Seite vorzugsweise immer zu dem zugeordneten Target 4 bzw. den beiden zugeordneten Targets 4.

Vorzugsweise verläuft die Drehachse D des jeweiligen Targets 4 senkrecht zu einer beliebigen bzw. mindestens einer Flächennormalen der zu beschichtenden Linse 2 bzw. Oberfläche.

Die Flächennormale des optischen oder geometrischen Zentrums der Linse 2 kann zur Rotationsachse A bzw. Drehachse D geneigt sein.

Die Linsenzentren sind vorzugsweise symmetrisch zum jeweiligen Target 4 in X-Richtung bzw. Längserstreckung des Targets 4 angeordnet.

Die zu beschichtenden Linsen 2 bzw. deren geometrische oder optische Zentren sind vorzugsweise zumindest im Wesentlichen in einer gemeinsamen Ebene angeordnet, wobei diese Ebene besonders bevorzugt parallel zu der Erstreckungsebene der Sputterquellen 3 bzw. Targets 4 bzw. Drehachsen D verläuft.

Mit der vorschlagsgemäßen Vorrichtung 1 bzw. dem vorschlagsgemäßen Verfahren bzw. der vorschlagsgemäßen Verwendung von rohrförmigen, parallelen Targets 4 zur Beschichtung von Linsen 2 werden vorzugsweise Beschichtungsraten von 0,001 bzw. 20 nm/s, insbesondere 0,005 nm/s bis 2,5 nm/s, erreicht.

Die Drehgeschwindigkeit der Linse 2 beträgt vorzugsweise 10 bis 200 U/min., insbesondere etwa 40 bis 120 U/min.

Der Durchmesser der Linsen 2 beträgt vorzugsweise etwa 40 bis 85 mm.

Die Drehgeschwindigkeit der Targets 4 beträgt vorzugsweise etwa 3 bis 30 U/min.

Vorzugsweise ist die Drehgeschwindigkeit der Linsen 2 größer als die der Targets 4, insbesondere beträgt diese mehr als 2- oder 3-fache der Drehgeschwindigkeit der Targets 4.

Die Beschichtungszeit beträgt vorzugsweise etwa 4 bis 7 min.

Die vorschlagsgemäße Vorrichtung 1 bzw. das vorschlagsgemäße Verfahren bzw. die vorschlagsgemäße Verwendung wird vorzugsweise zum Aufbringen einer oder mehrerer Antireflexschichten verwendet.

Vorschlagsgemäß erfolgt insbesondere ein reaktives Beschichten, wobei durch entsprechende Zuführung von Reaktiv-Gas, beispielsweise von Stickstoff, Wasserstoff und/oder Sauerstoff, zum Arbeits-Gas (Edelgas), insbesondere Argon, das Targetmaterial damit reagieren und eine gewünschte Beschichtung auf der Linse 2 bilden kann.

Es werden insbesondere eine Vorrichtung 1, ein Verfahren und eine Verwendung zur Beschichtung von Linsen 2 vorgeschlagen, wobei die zu beschichtenden Linsen paarweise über parallelen, rohrförmigen Targets 4 derart angeordnet werden, dass diese jeweils sowohl einen homogenen als auch einen inhomogenen Abtragungsbereich B1, B2 des Targets 4 überdecken und wobei die Linsen 2 rotieren, so dass eine besonders gleichmäßige Beschichtung erreichbar ist.

### Bezugszeichenliste:

- 1: Vorrichtung
- 2: Linse
- 3: Sputterquelle
- 4: Target
- 5: Magnetanordnung
- 6: Spannungsquelle
- 7: Beschichtungskammer
- 8: Einrichtung
- 9: Gaszuführung
- 10: Träger
- 11: Drehantrieb
- 12: Drehkopplung
- 13: Stellantrieb
- 14: Kulisse

- A: Rotationsachse der Linse
- B1: erster Bereich
- B2: zweiter Bereich
- D: Drehachse des Targets
- E: Abstand Linsenachse-Targetende
- F: Abstand der Targets bzw. Drehachsen
- G: Verstellrichtung
- H: Hauptrichtung
- L: Längserstreckung bzw. Länge des Targets
- M: Mittelebene
- N: Neigungswinkel
- P: Ratenprofil
- S: Sputterwolke
- T: Targetoberfläche
- V: Abstand Linsenachse-Targetachse
- W: Winkel
- Z: Abstand Linse-Target

## Patentansprüche

1. Vorrichtung (1) zur Beschichtung von Linsen (2), vorzugsweise Brillengläsern, mittels Sputtern, insbesondere Magnetronsputtern,
mit mindestens zwei Targets (4) und
mit einem Träger (10) zur Halterung mindestens einer zu beschichtenden Linse (2),
wobei die Targets (4) länglich oder rohrförmig ausgebildet sind,
wobei die Targets (4) zur Veränderung des Abstands (Z, F) zu der mindestens einen zu beschichtenden Linse (2) und/oder des Abstands der Targets (4) verstellbar sind,
**dadurch gekennzeichnet,**
**dass** die Vorrichtung (1) einen Stellantrieb (13) zur gemeinsamen Verstellung der Targets (4) aufweist.

2. Vorrichtung nach Anspruch 1, **dadurch gekennzeichnet, dass** die Vorrichtung (1) ausgebildet ist, so dass das Beschichten bei stationärer Linse (2) zu den Targets (4) erfolgt, und/oder dass die Linse (2) bei der Beschichtung um eine relativ zu den Targets (4) stationäre Achse (A) rotierbar ist.

3. Vorrichtung nach Anspruch 1 oder 2, **dadurch gekennzeichnet, dass** die Targets (4) schräg und/oder symmetrisch zu einer Mittelebene (M) verstellbar sind.

4. Vorrichtung nach einem der voranstehenden Ansprüche, **dadurch gekennzeichnet, dass** die Targets (4) jeweils in einer Zwangsführung, vorzugsweise Kulisse (14), verstellbar geführt sind.

5. Vorrichtung nach einem der voranstehenden Ansprüche, **dadurch gekennzeichnet, dass** die Targets (4) bzw. deren Drehachsen (D) parallel verlaufen.

6. Vorrichtung nach einem der voranstehenden Ansprüche, **dadurch gekennzeichnet, dass** die Vorrichtung (1) zur beidseitigen Beschichtung der mindestens einen zu beschichtenden Linse (2) ausgebildet ist, wobei die Targets (4) auf entgegengesetzten Seiten der Linse (2) und/oder des Trägers (10) angeordnet sind.

7. Vorrichtung nach einem der voranstehenden Ansprüche, **dadurch gekennzeichnet, dass** zwei Targets (4) auf einer Seite und zwei Targets (4) auf der entgegengesetzten Seite der Linse (2) und/oder des Trägers (10) angeordnet sind.

8. Verwendung von zwei länglichen bzw. rohrförmigen, parallelen Targets (4) zur Beschichtung von gekrümmten Oberflächen von Linsen (2), vorzugsweise Brillengläsern, mittels Sputtern, insbesondere Magnetronsputtern,
wobei die Targets (4) zur Veränderung des Abstands (Z, F) zu mindestens einer zu beschichtenden Linse (2) und/oder des Abstands der Targets (4) verstellt werden, um das Beschichtungsverhalten an die Linse (2) anzupassen,
**dadurch gekennzeichnet,**
**dass** die Targets (4) mittels eines Stellantriebs (13) gemeinsam verstellt werden.

9. Verfahren zur Beschichtung von Linsen (2), vorzugsweise Brillengläsern, mittels Sputtern, insbesondere Magnetronsputtern, wobei mindestens eine Linse (2) in einer Vorrichtung (1) bzw. Beschichtungskammer (7) beschichtet werden,
wobei zwei längliche oder rohrförmige Targets (4) zur Veränderung des Abstands (Z, F) zu der mindestens einen zu beschichtenden Linse (2) und/oder des Abstands der Targets (4) verstellt werden, um das Beschichtungsverhalten an die Linse (2) anzupassen,
**dadurch gekennzeichnet,**
**dass** die Targets (4) mittels eines Stellantriebs (13) gemeinsam verstellt werden.

10. Verfahren nach Anspruch 9, **dadurch gekennzeichnet, dass** der Abstand (F) der Targets (4) zueinander während des Beschichtens konstant bleibt.

11. Verfahren nach Anspruch 9 oder 10, **dadurch gekennzeichnet, dass** der Abstand (Z) der Linse (2) zu mindestens einem Target (4) während des Beschichtens konstant bleibt.

12. Verfahren nach einem der Ansprüche 9 bis 11, **dadurch gekennzeichnet, dass** das Beschichten bei stationärer Linse (2) zu dem Target (4) erfolgt.

13. Verfahren nach einem der Ansprüche 9 bis 12, **dadurch gekennzeichnet, dass** die Targets (4) schräg und/oder symmetrisch zu einer Mittelebene (M) verstellt werden.

14. Verfahren nach einem der Ansprüche 9 bis 13, **dadurch gekennzeichnet, dass** die Targets (4) bei der Verstellung jeweils in einer Zwangsführung, vorzugsweise Kulisse (14), geführt werden.

15. Verfahren nach einem der Ansprüche 9 bis 14, **dadurch gekennzeichnet, dass** die Linse (2) beidseitig in der Vorrichtung (1) bzw. Beschichtungskammer (7) von auf entgegengesetzten Seiten angeordneten Targets (4) beschichtet wird.

## Claims

1. Device (1) for coating lenses (2), preferably eyeglass lenses, by means of sputtering, in particular magnetron sputtering,
with at least two targets (4) and
with a carrier (10) for holding at least one lens (2) to be coated,
wherein the targets (4) are designed elongated or tubular,
wherein the targets (4) are adjustable to change the distance (Z, F) to the at least one lens (2) to be coated and/or the distance of the targets (4),
**characterized**
**in that** the device (1) has an adjustment drive (13) for common adjustment of the targets (4).

2. Device according to claim 1, **characterized in that** the device (1) is designed so that the coating is performed with stationary lens (2) to the targets (4) and/or that the lens (2) is rotatable during the coating about an axis (A) stationary relative to the targets (4).

3. Device according to claim 1 or 2, **characterized in that** the targets (4) are adjustable obliquely and/or symmetrically to a center plane (M).

4. Device according to one of the preceding claims, **characterized in that** the targets (4) are each adjustably guided in a restricted guidance, preferably a slotted guide (14).

5. Device according to one of the preceding claims, **characterized in that** the targets (4) and/or their axes of rotation (D) run parallel.

6. Device according to one of the preceding claims, **characterized in that** the device (1) is designed for two-sided coating of the at least one lens (2) to be coated, the targets (4) being arranged on opposite sides of the lens (2) and/or of the carrier (10).

7. Device according to one of the preceding claims, **characterized in that** two targets (4) are arranged on one side and two targets (4) are arranged on the opposite side of the lens (2) and/or the carrier (10).

8. Use of two elongated and/or tubular, parallel targets (4) for coating curved surfaces of lenses (2), preferably eyeglass lenses, by means of sputtering, in particular magnetron sputtering,
wherein the targets (4) are adjusted to change the distance (Z, F) to at least one lens (2) to be coated and/or the distance of the targets (4), in order to adapt the coating behavior to the lens (2),
**characterized**
**in that** the targets (4) are adjusted in common by means of an adjustment drive (13).

9. Method for coating lenses (2), preferably eyeglass lenses, by means of sputtering, in particular magnetron sputtering, wherein at least one lens (2) is coated in a device (1) and/or coating chamber (7),
wherein two elongate or tubular targets (4) are adjusted to change the distance (Z, F) to the at least one lens (2) to be coated and/or the distance of the targets (4), in order to adapt the coating behavior to the lens (2),
**characterized**
**in that** the targets (4) are adjusted in common by means of an adjustment drive (13).

10. Method according to claim 9, **characterized in that** the distance (F) of the targets (4) to each other remains constant during coating.

11. Method according to claim 9 or 10, **characterized in that** the distance (Z) of the lens (2) to at least one target (4) remains constant during coating.

12. Method according to one of claims 9 to 11, **characterized in that** the coating is performed with stationary lens (2) to the target (4).

13. Method according to one of claims 9 to 12, **characterized in that** the targets (4) are adjusted obliquely and/or symmetrically to a center plane (M).

14. Method according to one of claims 9 to 13, **characterized in that** the targets (4) are each guided in a restricted guidance, preferably a slotted guide (14), during the adjustment.

15. Method according to one of claims 9 to 14, **characterized in that** the lens (2) is coated on both sides in the device (1) and/or coating chamber (7) by targets (4) arranged on opposite sides.

## Revendications

1. Dispositif (1) pour le revêtement de lentilles (2), de préférence de verres de lunettes, par pulvérisation, en particulier par pulvérisation magnétron,
avec au moins deux cibles (4) et
avec un support (10) pour maintenir au moins une lentille (2) à revêtir,
les cibles (4) étant de forme allongée ou tubulaire,
les cibles (4) étant réglables pour modifier la distance (Z, F) à la au moins une lentille (2) à revêtir et/ou la distance des cibles (4),
**caractérisé**
**en ce que** le dispositif (1) présente un entraînement de réglage (13) pour le réglage commun des cibles (4).

2. Dispositif selon la revendication 1, **caractérisé en ce que** le dispositif (1) est conçu de telle sorte que le revêtement s'effectue avec la lentille (2) stationnaire par rapport aux cibles (4), et/ou **en ce que** la lentille (2) peut être mise en rotation autour d'un axe (A) stationnaire par rapport aux cibles (4) lors du revêtement.

3. Dispositif selon la revendication 1 ou 2, **caractérisé en ce que** les cibles (4) sont réglables obliquement et/ou symétriquement par rapport à un plan médian (M).

4. Dispositif selon l'une des revendications précédentes, **caractérisé en ce que** les cibles (4) sont chacune guidées de manière réglable dans un guidage forcé, de préférence une coulisse (14).

5. Dispositif selon l'une des revendications précédentes, **caractérisé en ce que** les cibles (4) et/ou leurs axes de rotation (D) sont parallèles.

6. Dispositif selon l'une des revendications précédentes, **caractérisé en ce que** le dispositif (1) est conçu pour revêtir les deux faces d'au moins une lentille (2) à revêtir, les cibles (4) étant disposées sur des côtés opposés de la lentille (2) et/ou du support (10).

7. Dispositif selon l'une des revendications précédentes, **caractérisé en ce que** deux cibles (4) sont disposées sur un côté et deux cibles (4) sont disposées sur le côté opposé de la lentille (2) et/ou du support (10).

8. Utilisation de deux cibles (4) parallèles, allongées et/ou tubulaires, pour le revêtement de surfaces courbes de lentilles (2), de préférence de verres de lunettes, par pulvérisation, en particulier par pulvérisation magnétron,
les cibles (4) étant réglées pour modifier la distance (Z, F) à au moins une lentille (2) à revêtir et/ou la distance des cibles (4), afin d'adapter le comportement de revêtement à la lentille (2),
**caractérisé**
**en ce que** les cibles (4) sont réglées ensemble au moyen d'un entraînement de réglage (13).

9. Procédé de revêtement de lentilles (2), de préférence de verres de lunettes, par pulvérisation, en particulier par pulvérisation magnétron, au moins une lentille (2) étant revêtue dans un dispositif (1) et/ou une chambre de revêtement (7),
deux cibles (4) allongées ou tubulaires étant réglées pour modifier la distance (Z, F) à la au moins une lentille (2) à revêtir et/ou la distance des cibles (4), afin d'adapter le comportement de revêtement à la lentille (2),
**caractérisé**
**en ce que** les cibles (4) sont réglées ensemble au moyen d'un entraînement de réglage (13).

10. Procédé selon la revendication 9, **caractérisé en ce que** la distance (F) entre les cibles (4) reste constante pendant le revêtement.

11. Procédé selon la revendication 9 ou 10, **caractérisé en ce que** la distance (Z) entre la lentille (2) et au moins une cible (4) reste constante pendant le revêtement.

12. Procédé selon l'une des revendications 9 à 11, **caractérisé en ce que** le revêtement est effectué avec la lentille (2) stationnaire par rapport à la cible (4).

13. Procédé selon l'une des revendications 9 à 12, **caractérisé en ce que** les cibles (4) sont réglées obliquement et/ou symétriquement par rapport à un plan médian (M).

14. Procédé selon l'une des revendications 9 à 13, **caractérisé en ce que** les cibles (4) sont guidées chacune dans un guidage forcé, de préférence une coulisse (14), lors du réglage.

15. Procédé selon l'une des revendications 9 à 14, **caractérisé en ce que** la lentille (2) est revêtue des deux côtés dans le dispositif (1) et/ou la chambre de revêtement (7) de cibles (4) disposées sur des côtés opposés.
